# EUROPÄISCHE PATENTANMELDUNG

(11) **EP 3 739 637 A1**
(43) Veröffentlichungstag der Anmeldung: **18.11.2020**
(21) Anmeldenummer: 19174699.9
(22) Anmeldetag: 15.05.2019
(51) Int. Cl.: H01L 31/0236, H01L 31/18

(54) **VERFAHREN ZUR HERSTELLUNG TEXTURIERTER SOLARWAFER**

(71) Anmelder: Meyer Burger (Germany) GmbH, 09337 Hohenstein-Ernstthal (DE)
(72) Erfinder: Breus, Vladimir, 09337 Hohenstein-Erstthal (DE); Wißen, Arne, 09337 Hohenstein-Ernstthal (DE)

(57) **Zusammenfassung**

Die vorliegende Erfindung betrifft ein Verfahren zur Herstellung wenigstens einseitig texturierter Solarwafer, wobei in einem ersten Verfahrensschritt gesägte Solarwafer mit Sägeschäden bereitgestellt werden und am Ende des letzten Verfahrensschrittes texturierte Solarwafer mit unterschiedlichen Größentypen von großen und kleinen Pyramiden bereitgestellt werden, und wobei die texturierten Solarwafer anschließend zu Solarzellen weiterverarbeitet werden können. Die Aufgabe der vorliegenden Erfindung liegt im Vorschlagen eines verbesserten Texturierungsverfahrens im Rahmen der Herstellungstechnologie von Solarzellen. Diese Aufgabe wird durch ein Verfahren zur Herstellung texturierter Solarwafer gelöst, wobei in dem ersten Texturätzschritt die großen Pyramiden in einer geringen Flächendichte angelegt werden, sodass am Ende des Verfahrens weniger als 30 % der texturierten Oberfläche des Solarwafers mit den großen Pyramiden belegt sind, wobei in dem zweiten Texturätzschritt die kleinen Pyramiden, mit einer großen Flächendichte hergestellt werden.

## Beschreibung

Die vorliegende Erfindung betrifft ein Verfahren zur Herstellung wenigstens einseitig texturierter Solarwafer, wobei in einem ersten Verfahrensschritt gesägte Solarwafer mit Sägeschäden bereitgestellt werden und am Ende des letzten Verfahrensschrittes texturierte Solarwafer mit unterschiedlichen Größentypen von großen und kleinen Pyramiden bereitgestellt werden, und wobei die texturierten Solarwafer anschließend zu Solarzellen weiterverarbeitet werden können. Außerdem betrifft die Erfindung auch eine mit dem Verfahren hergestellte Solarzelle und eine zur Durchführung des Verfahrens eingesetzte Fertigungslinie.

Bei der Herstellung von Solarzellen wird üblicherweise zumindest die primär für den Lichteinfall vorgesehene Vorderseite der Solarzelle aufgeraut bzw. texturiert. Diese Texturierung reduziert die Reflexion und erhöht die Absorption des einfallendenden Lichtes. Die Texturierung führt also zu einer Erhöhung des Wirkungsgrades der Solarzelle. Außerdem werden texturierte Solarzellenoberflächen oft als ästhetisch ansprechender wahrgenommen. Neben monofacialen Solarzellen gibt es auch bifaciale Solarzellen, die nicht nur auf Ihrer Vorderseite sondern auch auf ihrer Rückseite Licht in die Solarzelle einlassen können. Texturierungen können sowohl auf der Vorderseite als auch auf der Rückseite der Solarzelle hergestellt werden, um einen Nutzen zu generieren. Solarzellen werden derzeit und in den nächsten Jahren von der globalen Solarzellenindustrie überwiegend aus einkristallinen Si-Wafern hergestellt. Diese monokristallinen Solarwafer werden meistens mit anisotropen Ätzmitteln, beispielsweise mit KOH-haltigen Ätzlösungen, texturiert, wobei an den geätzten Oberflächen Pyramiden mit Seitenflächen in der 111-Kristallebenen des Silizium-Einkristalls zurückbleiben, die die Texturierung auf dem Solarwafer ausbilden. Ein herkömmliches Texturierungsverfahren, das industriell zur Texturierung von Solarwafern eingesetzt werden kann, ist in DE10 2008 014 166 B3 beschrieben.

Solarzellen und Ihre Herstellungsverfahren wurden in den letzten Jahren erheblich verbessert, die Leistungsfähigkeit der Solarzellen wurde gesteigert und die Herstellungskosten wurden reduziert. Schon heute ist die Photovoltaik die kostengünstigste und umweltfreundlichste Möglichkeit der Elektroenergieerzeugung. In Zukunft gilt es, die Solarzellenfertigungsverfahren weiterzuentwickeln, um die Leistungsfähigkeit von Solarzellen weiter zu erhöhen und die Kosten von aus Solarstrahlung gewonnener Elektroenergie weiter zu reduzieren. Hochleistungssolarzellen, z.B. HJT-Solarzellen, sind sehr empfindlich gegenüber Verschmutzungen während des Herstellungsverfahrens, Verschmutzungsmechanismen müssen entsprechend erkannt und ihre Wirkungen minimiert werden. Es ist deshalb die Aufgabe der vorliegenden Erfindung, im Rahmen der Herstellungstechnologie von Solarzellen ein verbessertes Texturierungsverfahren vorzuschlagen.

Diese Aufgabe wird durch ein Verfahren zur Herstellung texturierter Solarwafer gelöst, wobei in dem ersten Texturätzschritt die großen Pyramiden in einer geringen Flächendichte angelegt werden, sodass am Ende des Verfahrens weniger als 30% der texturierten Oberfläche des Solarwafers mit den großen Pyramiden belegt sind, wobei in dem zweiten Texturätzschritt die kleinen Pyramiden, mit einer großen Flächendichte hergestellt werden. Dieses Verfahren ist besonders einfach und kostengünstig durchführbar. Die großen Pyramiden werden nicht nur zu dem Zweck hergestellt, mehr Licht in die Solarzelle zu leiten als bei glatten Solarzellenoberflächen. Zusätzlich erfüllen die großen Pyramiden den Zweck, kleinflächige Kontaktbereiche zwischen dem Solarwafer und den im Herstellungsverfahren von Solarzellen verwendeten Transportvorrichtungen bereitzustellen. Bei den Transportvorrichtungen kann es sich beispielsweise um Transportbänder handeln. An den übrigen Oberflächenbereichen des Solarwafers, also den Oberflächenbereichen mit den kleinen Pyramiden, wird dadurch ein Kontakt mit den Transportbändern oder anderen Vorrichtungsteilen, auf denen die Solarwafer aufliegen, weitgehend vermieden. Ein Abrieb der Texturierung bzw. der kleinen Pyramiden wird somit minimiert und die Qualität und der mittlere Wirkungsgrad der hergestellten Solarzellen steigt. Die Oberflächenbereiche des Solarwafers zwischen den großen Pyramiden sind in der Regel vollständig mit kleinen Pyramiden gefüllt. Die verschieden großen Pyramiden werden an Hand ihrer mechanischen bzw. optischen Funktion in Transportpyramiden und kleinere Lichtsammel-Pyramiden unterschieden. Da nur die großen Pyramiden in Kontakt mit den Transportvorrichtungen kommen, können die Solarzellen transportiert werden, ohne dass die kleinen Pyramiden bzw. die Lichtsammel-Pyramiden in einen Kontakt mit den Transportvorrichtungen kommen. Unter kleinen Pyramiden werden in diesen Zusammenhang alle Pyramiden verstanden, die kleiner als die großen Pyramiden sind. Die großen Pyramiden haben während des Herstellungsverfahrens die Aufgabe von Transportpyramiden, welche Transportvorrichtungen berühren, sodass eine die Solarwafer ausschließlich mit den Spitzen der großen Pyramiden auf den Transportvorrichtungen aufliegen. Aus statistischer Sicht kann die Größenverteilung der Pyramiden eine 2-fach-Verteilung sein, die teilweise auch als bimodale, zwei-Spitzen- oder zwei-Gipfel-Verteilung bezeichnet wird. Die Größenverteilung kann aber auch eine Mehrfach-Verteilung sein, von der die verschieden großen Pyramiden anhand ihrer Funktion den beiden Kategorien von großen und kleinen Pyramiden zugeordnet werden.

Der erste Texturätzschritt des erfindungsgemäßen Verfahrens kann sich in einem zweiten Verfahrensschritt unmittelbar an den ersten Verfahrensschritt anschließen, in dem Solarwafer mit Sägeschäden bereitgestellt werden. Somit entfallen die herkömmlichen Verfahrensschritte, die der Entfernung von oberflächlichen Kristallschäden an der Oberfläche des Solarwafers dienen, die beim Zersägen eines Bricks entstandenen sind. Der erste Texturätzschritt übernimmt also neben der Aufgabe, wenige große Pyramiden herzustellen, auch die Zusatzaufgabe, Sägeschäden zu entfernen. Im Vergleich zu herkömmlichen Verfahren werden im erfindungsgemäßen Verfahren erheblich weniger Chemikalien verbraucht.

Der erste Texturätzschritt kann mit einer zwischen 1 und 15 % KOH oder NaOH oder NH₄OH oder TMAH enthaltenden ersten Textur-Ätzlösung durchgeführt werden. Diese basischen Chemikalien haben die gewünschte anisotrope Ätzwirkung, die zur Herstellung der Pyramiden benötigt werden. Die Festlegung der konkreten Ätzparameter, insbesondere der verwendeten Konzentration und der Temperatur erfolgt mit fachmännischen Mitteln anhand von lokalen Zielparametern, insbesondere werden sie hinsichtlich der Textur-Topologie, der Durchlaufzeit und des Chemikalienverbrauchs optimiert. Die erste Textur-Ätzlösung kann ein Texturadditiv enthalten. Texturadditive und Ihre Wirkungen sind im Stand der Technik bekannt, sodass deren Beschreibung hier für den Fachmann entbehrlich ist. Die Textur-Additive werden temporär lokal an die Siliziumoberfläche angelagert, so dass sie lokal die Oberfläche maskieren und die Entstehung von Pyramidenspitzen bewirken können. Als Additiv können beispielsweise kommerziell verfügbare Texturadditive, Tenside, einfache Alkohole oder mehrfache Alkohole, organische Säuren, Esther, Ether, Aldehyde, Ketone, Saccharide (mono-, Di-, Tri-, oligo- oder poly-) eingesetzt werden. Die erste Textur-Ätzlösung enthält weniger Ätzmittel als ein herkömmliches Ätzbad zur Entfernung von Sägeschäden, das typischerweise 20% KOH enthält. Sowohl beim Ansetzen als auch beim Nachdosieren der Textur-Ätzlösung wird im erfindungsgemäßen Verfahren weniger Ätzmittel eingesetzt als in einem herkömmlichen Verfahren. Bei Verwendung des erfindungsgemäßen Verfahrens konnten bis zu 45% Chemikalien- und entsprechende Kosten-Einsparungen gezeigt werden.

Der zweite Texturätzschritt kann mit einer zwischen 1 und 5 %-igen KOH oder NaOH oder NH₄OH oder TMAH und ein Texturadditiv enthaltenden zweiten Textur-Ätzlösung durchgeführt werden. Als Additiv können beispielsweise kommerziell verfügbare Texturadditive, Tenside, Alkohole (einfach & mehrfach), organische Säuren, Esther, Ether, Aldehyde, Ketone, Saccharide (mono-,Di-,Tri-, oligo-, poly-) eingesetzt werden.

Zwischen dem ersten Texturätzschritt und dem zweiten Texturätzschritt kann wenigstens ein Spülschritt durchgeführt wird. Mit Spülschritten können verschiedene chemische Behandlungen voneinander gut separiert und die einzelnen Prozessschritte gut kontrolliert werden. Insbesondere im Massengeschäft der Solarzellenfertigung sind Minimierungen der Fertigungskosten sehr bedeutsam. Ein Weglassen von Spülschritten kann deshalb auch dann entschieden werden, wenn damit andere Nachteile in Kauf genommen werden müssen. Prinzipiell kann das Texturieren der Solarzellen lediglich mit den beiden Texturätzschritten durchgeführt werden. Zwischen dem ersten Texturätzschritt und dem zweiten Texturätzschritt und/oder wenigstens einem Spülschritt kann wenigstens ein Reinigungsschritt durchgeführt werden. Mit Reinigungsschritten kann der Einfluss zufälliger Verunreinigungen reduziert und die Ausbeute an texturierten Solarwafern mit gleichmäßig höchster Qualität erhöht werden. Der Reinigungsschritt kann beispielsweise in einem SC1-Bad, oder einem pSC1-Bad (modifizierte Standardreinigung / pseudo standard clean), oder in einer Wasser, Ozon und HCl enthaltenden Lösung, oder in einer Wasser, Ozon, HF und HCl enthaltenden Lösung, oder in HF und HCl enthaltenden Lösungen oder in HCl-Lösungen bei Temperaturen zwischen 10°C und 80°C, oder in HNO₃-Lösungen bei 50-80°C, oder in DI-Wasser bei 10-80°C, oder in verdünnten KOH-Lösungen mit einer Konzentration ≤ 1% bei Temperaturen zwischen 50 und 90°C durchgeführt werden. Die Reinigung kann mit Ultraschall unterstützt werden. Statt eines Reinigungsbades kann auch eine Oxidation in einer Ozon enthaltenden Gasatmosphäre genutzt werden. Prinzipiell funktionieren die Texturierungsschritte aber auch ohne zwischengeschaltete Reinigungen.

Die großen Pyramiden können in dem erfindungsgemäßen Verfahren auf weniger als 10% der texturierten Oberfläche, vorzugsweise auf 5%, der texturierten Oberfläche und die kleinen Pyramiden können auf mehr als 90%, vorzugsweise auf 95%, der texturierten Oberfläche des Solarwafers hergestellt werden. Je geringer die Anzahl großer Pyramiden ist, desto kleiner sind die insgesamt aufsummierten Kontaktflächen zwischen dem Solarwafer und Transportvorrichtungen, die bei der Herstellung von Solarzellen aus den Solarwafern verwendet werden. Bei kleineren Kontaktflächen kann weniger Abrieb bzw. weniger Transportschaden entstehen. Dadurch können Verunreinigungen reduziert werden und die Wirkungsgrade der hergestellten Solarzellen gesteigert werden.

Das Verfahren zur Herstellung texturierter Solarwafer kann sich unmittelbar in der zur Durchführung des Verfahrens verwendeten Fertigungslinie wiederspiegeln. Insofern betrifft die Erfindung auch eine Fertigungslinie mit entsprechenden Bädern zur Durchführung des erfindungsgemäßen Verfahrens. Die Fertigungslinie ist entsprechend dem gewünschten Ergebnis ausgestattet. Wenn beispielsweise der Solarwafer nur einseitig texturiert werden soll, ohne dass eine Seite der Wafer durch eine Schutzschicht maskiert ist, dann ist die Fertigungslinie entsprechend zur einseitigen Bearbeitung des Wafers ausgestattet. Wenn eine zweiseitige Texturierung gewollt ist, dann werden die Wafer vollständig in Bäder eingetaucht und entsprechend ausgestattete Fertigungslinien verwendet.

In einem weiteren Aspekt betrifft die vorliegende Erfindung eine Solarzelle, welche aus einem mit dem erfindungsgemäßen Verfahren hergestellten Solarwafer hergestellt ist. In der fertigen Solarzelle zeugen die verschieden großen Pyramiden von der Verwendung des erfindungsgemäßen Verfahrens während der Herstellung der Solarzellen. Die kleinen Kontaktflächen mit Transportvorrichtungen nur an den Spitzen der großen Pyramiden führen zu höheren Ausbeuten, höheren Wirkungsgraden und geringen Herstellungskosten als bei der Verwendung herkömmlicher Texturierungsverfahren. Dies gilt insbesondere für Heterojunktion-Solarzellen, die gegenüber Verunreinigungen, Transportschäden und Abrieb während des Herstellungsverfahrens empfindlicher sind als andere Solarzellentypen.

Die Solarzelle kann eine Dicke unter 150 µm haben. Das erfindungsgemäße Verfahren ist kompatibel mit sehr dünnen Solarwafern mit einer Dicke von beispielsweise 120 µm oder 100 µm. Bei sehr dünnen Solarwafern werden die vorteilhaften Effekte des erfindungsgemäßen Verfahren stärker wirksam als bei dickeren Wafern, weil bei dünneren Wafern das Verhältnis von Oberfläche zu Volumen größer ist, und dadurch die sauberere und definiertere Oberfläche an dünneren Wafern eine stärkere Wirkung entfaltet als an dickeren Wafern.

Verschiedene Optionen der vorliegenden Erfindung können im Ermessen eines Fachmanns miteinander kombiniert werden. Eine Angabe vieler Kombinationen und Ausgestaltungen würde einen Fachmann mehr stören als sie ihm nützen. Zufällig nacheinander angegebene Optionen dürfen nicht als zwingende Merkmalsinterpretation fehlinterpretiert werden.

Die vorliegende Erfindung soll im Folgenden anhand von Figuren weiter erläutert werden, wobei
- Fig. 1: ein herkömmliches Verfahren zur Herstellung texturierter Solarwafer,
- Fig. 2: ein erfindungsgemäßes Verfahren zur Herstellung texturierter Solarwafer,
- Fig. 3: einen schematischen Querschnitt durch einen texturierten Oberflächenabschnitt eines Solarwafers und
- Fig. 4: eine beispielhafte Größenverteilung von Textur-Pyramiden zeigt.

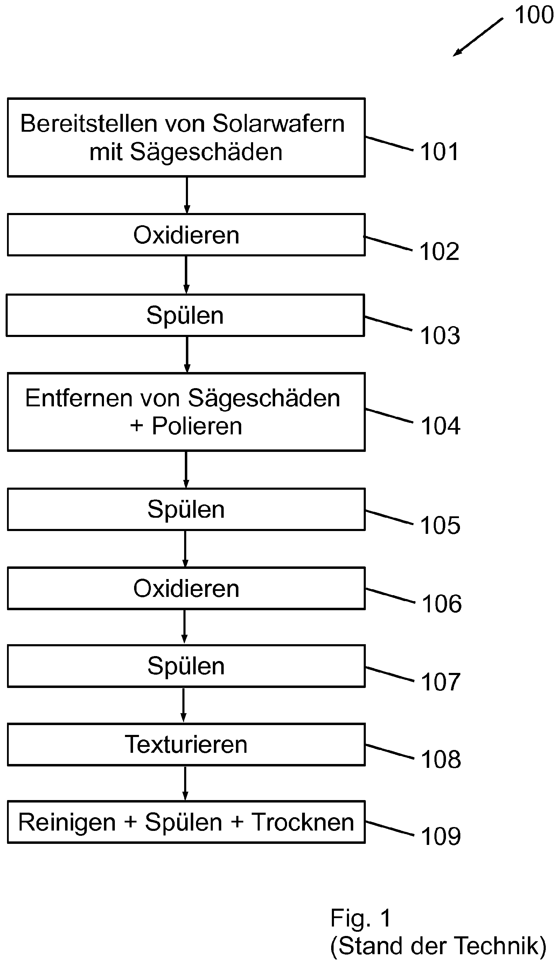

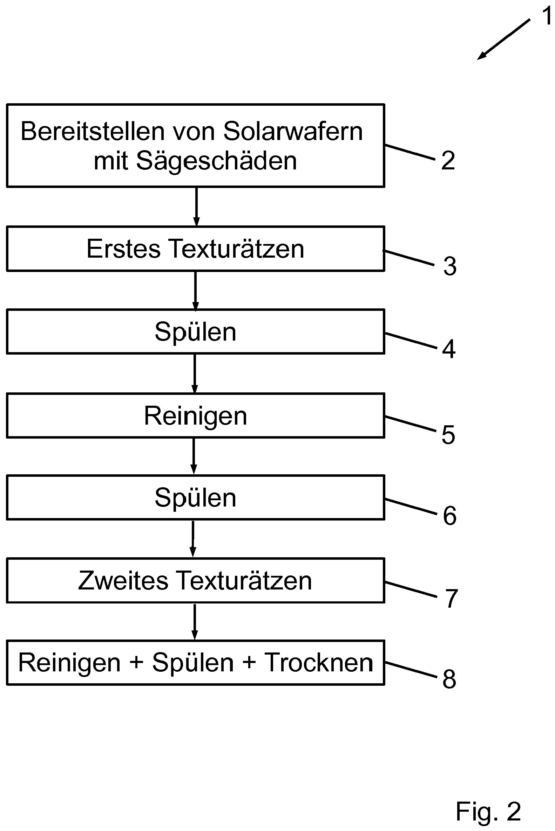

Figur Fig. 1 veranschaulicht ein herkömmliches Texturierungsverfahren 100 aus dem Stand der Technik, um eine Referenz für anschließende Vorstellung des erfindungsgemäßen Verfahrens in Fig. 2 bereitzustellen. In dem Verfahren 100 aus dem Stand der Technik werden in einem ersten Verfahrensschritt 101 gesägte Solarwafer mit Sägeschäden bereitgestellt. Dann werden die Wafer in einem Verfahrensschritt 102 in einem Flüssigkeitsbad chemisch oxidiert, wobei das Oxidieren mit nachfolgenden Ätzschritt zusammenwirkt. Anschließend an ein Spülen 103 erfolgt im Verfahrensschritt 104 das Entfernen von Sägeschäden und ein chemisches Polieren in einem marktüblichen Sägeschadenätzbad, das 20% KOH enthält. Im nächsten Schritt 105 wird gespült, dann wird im Schritt 106 oxidiert, um das Texturieren vorzubereiten. Nach einem weiteren Spülschritt 107 erfolgt der Texturierungsschritt 108. Im letzten Verfahrensschritt 109 werden die Wafer noch abschließend behandelt, insbesondere gereinigt, gespült und getrocknet. Im Ergebnis liegen dann texturierte Solarwafer vor, die als Zwischenprodukte zur späteren Herstellung von Solarzellen dienen.

Fig. 2 veranschaulicht ein Ausführungsbeispiel des erfindungsgemäßen Verfahrens. Im ersten Verfahrensschritt 2 erfolgt die Bereitstellung gesägter Solarwafer mit Sägeschäden. Unmittelbar anschließend erfolgt der erste Texturätzschritt 3, in welchem die großen Pyramiden erzeugt werden. Die KOH-Konzentration beträgt im vorgestellten Ausführungsbeispiel 3%. Im Vergleich zu einem Standard-Verfahren mit einem Ätzschadenentfernungsbad mit einer KOH Konzentration von 20 % werden 45% des insgesamt verbrauchten KOHs und entsprechende Kosten eingespart. Anschließend erfolgen ein Spülschritt 4, ein Reinigungsschritt 5 und ein weiterer Spülschritt 6. In dem Reinigungsschritt 5 wird vorliegend eine Ozon und HCl enthaltende Lösung verwendet. Da Ozon kostengünstig aus Sauerstoff hergestellt werden kann, kommt diese Reinigung mit geringsten Kosten aus. Dann erfolgt in dem zweiten Texturätzschritt 7 die Fertigstellung der großen Pyramiden 11 und die Herstellung der kleinen Pyramiden 12. Der Verfahrensschritt 8 stellt den Abschluss des erfindungsgemäßen Verfahrens zur Herstellung texturierter Solarwafer dar. Im vorgestellten Ausführungsbeispiel umfasst der abschließende Verfahrensschritt 8 einen Spül-Teilschritt, einen Reinigungsteilschritt, einen weiteren Spülteilschritt und einen Trocknungsteilschritt. In anderen Ausführungsbeispielen wird der abschließende Verfahrensschritt 8 abgewandelt durchgeführt. Nach dem abschließenden Verfahrensschritt 8 ist das erfindungsgemäße Verfahren 1 zur Herstellung texturierter Solarwafer 10 beendet.

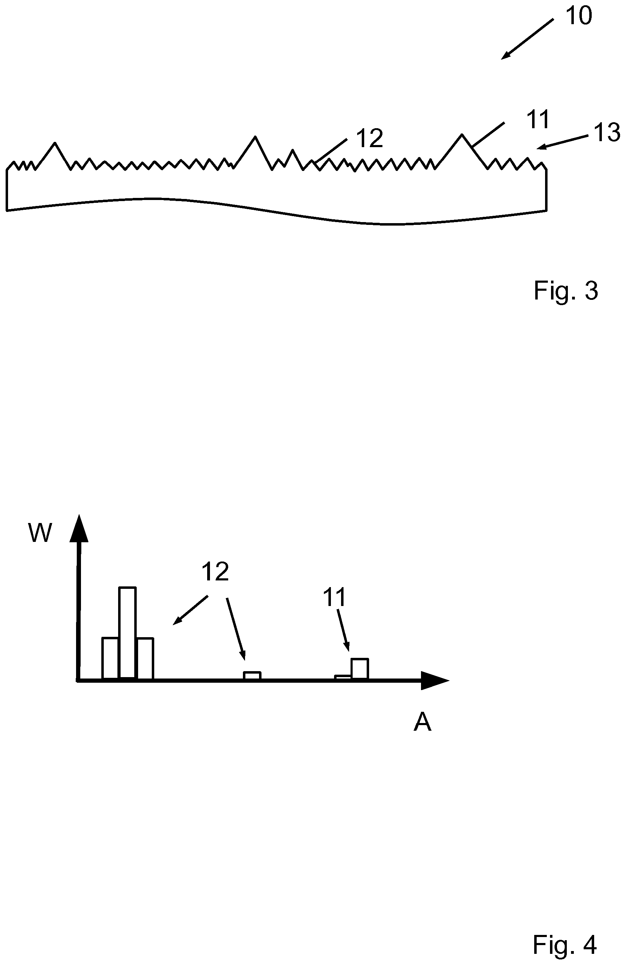

Fig. 3 zeigt schematisch eine der beiden erfindungsgemäß texturierten Oberflächen 13 eines texturierten Solarwafers 10 in einem Querschnitt durch einen Oberflächenabschnitt des Solarwafers 10. In diesem Querschnitt kann anhand unterschiedlicher Größen zwischen großen Pyramiden 11 und kleinen Pyramiden 12 unterschieden werden. Beispielsweise haben die großen Pyramiden 11 eine Höhe von 6 µm und die meisten kleinen Pyramiden 12 haben eine Höhe von 2µm.

Fig. 4 skizziert mögliche Wahrscheinlichkeiten W der Oberflächenbelegung des Solarwafers mit Pyramiden mit unterschiedlich großen Grundflächen A. An der Größe der Balken ist zu erkennen, dass die großen Pyramiden 11 mit großen Grundflächen A mit einer geringeren Wahrscheinlichkeit auf der Oberfläche des Solarwafers anzutreffen sind als kleine Pyramiden 12. Zu den kleinen Pyramiden 12 zählen in diesem Ausführungsbeispiel sowohl die kleinen Pyramiden mit annährend gleicher Größe als auch mittelgroße Pyramiden. Die mittelgroßen Pyramiden sind hinreichend klein, so dass ein auf den großen Pyramiden 11 auf einer Transportvorrichtung aufliegender Solarwafer nicht mit den mittelgroßen Pyramiden in Berührung kommt. An den mittelgroßen Pyramiden tritt folglich kein Abrieb auf und diese sind hier der Kategorie "kleine Pyramiden 12" zuzuordnen.

### Bezugszeichen

- 1: Verfahren zur Herstellung wenigstens einseitig texturierter Solarwafer
- 2: erster Verfahrensschritt: Bereitstellung gesägte Solarwafer mit Sägeschäden
- 3: erster Texturätzschritt
- 4: Spülschritt
- 5: Reinigungsschritt
- 6: Spülschritt
- 7: zweiter Texturätzschritt
- 8: abschließender Verfahrensschritt, dessen Zwischenprodukt texturierte Solarwafer sind
- 10: Solarwafer
- 11: große Pyramiden
- 12: kleine Pyramiden
- 13: texturierte Oberfläche(n) des Solarwafers
- A: Grundfläche einer Textur-Pyramide
- W: Wahrscheinlichkeit des Auftretens einer Pyramidengröße
- 100: Verfahren aus dem Stand der Technik
- 101: erster Verfahrensschritt: Bereitstellung gesägte Solarwafer mit Sägeschäden
- 102: Oxidieren
- 103: Spülen
- 104: Entfernen von Sägeschäden und Polieren
- 105: Spülen
- 106: Oxidieren
- 107: Spülen
- 108: Texturieren
- 109: abschließender Verfahrensschritt

## Patentansprüche

1. Verfahren (1) zur Herstellung wenigstens einseitig texturierter Solarwafer (10), wobei in einem ersten Verfahrensschritt (2) gesägte Solarwafer mit Sägeschäden bereitgestellt werden und am Ende des letzten Verfahrensschrittes (8) texturierte Solarwafer mit unterschiedlichen Größentypen von großen (11) und kleinen Pyramiden (12) bereitgestellt werden, und wobei die texturierten Solarwafer (10) anschließend zu Solarzellen weiterverarbeitet werden können,
**dadurch gekennzeichnet, dass** das Verfahren (1) einen ersten Texturätzschritt (3) und einen zweiten Texturätzschritt (7) aufweist, wobei in dem ersten Texturätzschritt (3) die großen Pyramiden (11) in einer geringen Flächendichte angelegt werden, sodass am Ende des Verfahrens weniger als 30% der texturierten Oberfläche des Solarwafers (10) mit den großen Pyramiden belegt sind, und wobei in dem zweiten Texturätzschritt (7) die kleinen Pyramiden (12), mit einer großen Flächendichte herstellt werden.

2. Verfahren (1) nach Anspruch 1, **dadurch gekennzeichnet, dass** der erste Texturätzschritt (3) sich in einem zweiten Verfahrensschritt unmittelbar an den ersten Verfahrensschritt (2) anschließt.

3. Verfahren (1) nach Anspruch 1 oder 2, **dadurch gekennzeichnet, dass** der erste Texturätzschritt (3) mit einer zwischen 1 und 15 % KOH oder NaOH oder NH4OH oder TMAH enthaltenden ersten Textur-Ätzlösung durchgeführt wird.

4. Verfahren (1) nach Anspruch 3, **dadurch gekennzeichnet, dass** die erste Textur-Ätzlösung ein Texturadditiv enthält.

5. Verfahren (1) nach wenigstens einem der vorhergehenden Ansprüche, **dadurch gekennzeichnet, dass** der zweite Texturätzschritt (7) mit einer zwischen 1 und 5 % KOH oder NaOH oder NH₄OH oder TMAH und ein Texturadditiv enthaltenden zweiten Textur-Ätzlösung durchgeführt wird.

6. Verfahren (1) nach Anspruch 1, **dadurch gekennzeichnet, dass** zwischen dem ersten Texturätzschritt (3) und dem zweiten Texturätzschritt (7) wenigstens ein Spülschritt (4, 6) durchgeführt wird.

7. Verfahren (1) nach Anspruch 1 oder 6, **dadurch gekennzeichnet, dass** zwischen dem ersten Texturätzschritt (3) und dem zweiten Texturätzschritt (7) und /oder wenigstens einem Spülschritt (4, 6) wenigstens ein Reinigungsschritt (5) durchgeführt wird.

8. Verfahren (1) nach wenigstens einem der vorhergehenden Ansprüche **dadurch gekennzeichnet, dass** die großen Pyramiden (11) auf weniger als 10% der texturierten Oberfläche (13), vorzugsweise auf 5%, der texturierten Oberfläche (13) und die kleinen Pyramiden (12) auf mehr als 90%, vorzugsweise auf 95%, der texturierten Oberfläche (13) des Solarwafers (10) hergestellt werden.

9. Fertigungslinie , **dadurch gekennzeichnet, dass** die Fertigungslinie zur Durchführung des Verfahrens (1) nach wenigstens einem der Ansprüche 1-8 mit entsprechenden Bädern ausgestattet ist.

10. Solarzelle, **dadurch gekennzeichnet, dass** die Solarzelle aus einem mit dem Verfahren nach wenigstens einem der Ansprüche 1-8 hergestellten Solarwafer (10) hergestellt ist.

11. Solarzelle nach Anspruch 10, **dadurch gekennzeichnet, dass** die Solarzelle eine Dicke unter 150 µm hat.
